# DEMANDE DE BREVET EUROPEEN

(11) **EP 2 259 319 A1**
(43) Date de publication de la demande: **08.12.2010**
(21) Numéro de dépôt: 10163772.6
(22) Date de dépôt: 25.05.2010
(51) Int. Cl.: H01L 27/16

(54) **Procédé de génération d'énergie électrique dans un circuit intégré lors du fonctionnement de celui-ci, circuit intégré correspondant et procédé de fabrication.**

(30) Priorité: 04.06.2009 FR 0953703
(71) Demandeur: STMicroelectronics (Rousset) SAS, 13790 Rousset (FR)
(72) Inventeur: Rivero, Christian, 13080 Luynes (FR); Fornara, Pascal, 83910 Pourrieres (FR)
(74) Mandataire: Zapalowicz, Francis

(57) **Abrégé**

Circuit intégré, comprenant au moins une région (RG) contenant au moins un matériau thermoélectrique (MTH) et configurée pour être soumise à au moins un gradient de température résultant d'une circulation d'un courant électrique dans moins une partie du circuit intégré (PSTA, PSTB) lors de son fonctionnement, et des moyens de sortie électriquement conducteurs couplés à ladite ou auxdites régions pour délivrer l'énergie électrique produite par le ou les matériaux thermoélectriques.

## Description

L'invention concerne les circuits intégrés, et plus particulièrement la génération d'énergie électrique dans un circuit intégré autre que celle produite par une alimentation classique comme par exemple une batterie.

Selon un mode de mise en oeuvre et de réalisation, il est ainsi proposé un procédé et un circuit intégré permettant de récupérer de l'énergie électrique à partir du fonctionnement propre du circuit intégré, pour éventuellement stocker cette énergie électrique afin de pouvoir par exemple alimenter une partie spécifique du circuit intégré et/ou recharger une batterie. Il devient alors possible d'augmenter considérablement la durée de vie de la batterie et/ou de diminuer la taille de celle-ci.

Selon un aspect, il est proposé un procédé de génération d'énergie dans un circuit intégré, comprenant une production d'au moins un gradient de température dans au moins une région du circuit intégré résultant d'une circulation d'un courant électrique dans au moins une partie du circuit intégré lors de son fonctionnement, et une production d'énergie électrique à partir d'au moins un matériau thermoélectrique contenu dans ladite ou lesdites régions soumises audit ou auxdits gradients de température.

Les inventeurs ont en effet observé que lors du fonctionnement d'une partie au moins du circuit intégré, il se produisait dans certaines régions de celui-ci, en particulier entre les différents niveaux d'interconnexion électrique, des gradients de température résultant de la circulation de courants électriques, par exemple des impulsions électriques, provoquées par, par exemple, le basculement de portes logiques, de registres, de bascules, la commutation de transistors, ...

Et, selon l'interconnexion de ces différents composants, la propagation de ces impulsions électriques provoque à certains moments et dans certaines régions du circuit intégré, des gradients de température.

Le matériau thermoélectrique va permettre par conséquent de produire de l'énergie électrique, et plus précisément un courant électrique, à partir du gradient thermique auquel il est soumis.

Il convient de noter ici que le procédé mis en oeuvre n'utilise aucun composant spécifique chauffant ou refroidissant, dont la seule fonction serait de provoquer le gradient de température. Au contraire, on utilise les propres éléments du circuit intégré, comme par exemple le réseau d'interconnexion, pour la production du ou des gradients thermiques.

Classiquement, un circuit intégré comporte une partie communément désignée par l'homme du métier sous la dénomination anglosaxonne « front-end-of-line » (FEOL) surmontée d'une deuxième partie communément désignée par l'homme du métier sous la dénomination anglosaxonne « back-end-of-line » (BEOL).

La partie FEOL est en fait la première partie fabriquée du circuit intégré dans laquelle se trouvent les composants actifs habituels tels que par exemple des transistors, des résistances,... La partie FEOL englobe généralement tous les différents éléments du circuit intégré jusqu'à la première couche de métallisation.

La partie supérieure du circuit intégré, à savoir la partie BEOL, est la partie du circuit intégré dans laquelle les composants actifs sont interconnectés par l'intermédiaire d'un réseau d'interconnexion comportant des niveaux de métallisation formant des pistes ou lignes d'interconnexion, et des vias. Cette partie BEOL commence généralement avec le premier niveau de métallisation et elle inclut également les vias, les couches isolantes ainsi que les plots de contact disposés sur la partie supérieure du circuit intégré.

Bien que la ou lesdites régions thermoélectriques puissent être disposées dans toute partie du circuit intégré qui est susceptible d'être soumise à un gradient de température, il est particulièrement avantageux et simple de loger le ou les matériaux thermoélectriques dans une ou plusieurs régions réalisées au voisinage d'une ou de plusieurs portions de réseau d'interconnexion, c'est-à-dire dans la partie BEOL du circuit intégré. En effet, il a été observé que la circulation du courant électrique dans au moins une partie du réseau d'interconnexion lors du fonctionnement d'au moins une partie du circuit intégré permettait de produire des gradients de température aisément utilisables.

La localisation des gradients de température dans le circuit intégré dépend en particulier des caractéristiques internes du circuit intégré et de son fonctionnement prévu, et notamment du type de composants actifs, de la façon dont ils sont interconnectés et de la façon dont ils sont utilisés et mis en oeuvre lors du fonctionnement du circuit intégré.

Cette localisation des gradients de température, notamment au sein du réseau d'interconnexion, peut aisément s'effectuer par exemple par simulation à partir d'une ou de plusieurs simulations de fonctionnement du circuit intégré dans des situations de fonctionnement prévisibles.

Et une fois cette localisation des gradients de température effectuée, il est alors aisé de localiser les régions destinées à contenir un ou des matériaux thermoélectriques.

Lorsque le réseau d'interconnexion comprend plusieurs niveaux d'interconnexion, ce qui est généralement le cas, on peut réaliser l'une au moins desdites régions thermoélectriques sur et entre des niveaux d'interconnexion différents.

On peut également réaliser l'une au moins desdites régions thermoélectriques sur un même niveau d'interconnexion.

Selon un mode de mise en oeuvre, on peut également réaliser l'une au moins desdites régions thermoélectriques de façon à ce qu'elle avoisine au moins deux zones de diffusivité thermique différentes d'un enrobage électriquement isolant (par exemple un diélectrique interniveaux) d'une portion du réseau d'interconnexion. On peut réaliser par exemple une poche d'air dans cet enrobage isolant, communément désignée par l'homme du métier sous la dénomination anglosaxonne de « air gap », ce qui permet de créer une zone de basse diffusivité thermique.

L'énergie produite par le matériau thermoélectrique peut être utilisée à différentes fins. On peut par exemple stocker cette énergie dans un moyen de stockage, par exemple un condensateur, ménagé dans le circuit intégré. Ce condensateur pourrait être un condensateur métal-métal, par exemple réalisé dans la partie BEOL, ou bien un condensateur réalisé dans la partie FEOL.

Selon un autre aspect, il est proposé un circuit intégré comprenant au moins une région contenant au moins un matériau thermoélectrique et configurée pour être soumise à au moins un gradient de température résultant d'une circulation d'un courant électrique dans moins une partie du circuit intégré lors de son fonctionnement, et des moyens de sortie électriquement conducteurs couplés à ladite ou auxdites régions pour délivrer l'énergie électrique produite par le ou les matériaux thermoélectriques.

Selon un mode de réalisation, le circuit intégré comprend des composants actifs et un réseau d'interconnexion électriquement conducteur entre les composants actifs, et ladite ou lesdites régions contenant au moins un matériau thermoélectrique et configurées pour être soumises à au moins un gradient de température sont situées au voisinage d'une ou de plusieurs portions du réseau d'interconnexion.

Selon un mode de réalisation, le réseau d'interconnexion comprend plusieurs niveaux d'interconnexion, et l'une au moins desdites régions s'étend sur et entre des niveaux d'interconnexion différents.

Selon un mode de réalisation, le réseau d'interconnexion comprend plusieurs niveaux d'interconnexion, et l'une au moins desdites régions s'étend sur un même niveau d'interconnexion.

Selon un mode de réalisation, l'une au moins desdites régions avoisine au moins deux zones de diffusivités thermiques différentes d'un enrobage électriquement isolant d'une portion du réseau d'interconnexion.

L'une des deux zones peut comporter une poche d'air.

Selon un mode de réalisation, l'une au moins desdites régions s'étend entre l'une au moins des parties des lignes d'interconnexion.

Selon un mode de réalisation, le circuit intégré comprend en outre des moyens de stockage d'énergie électrique, électriquement couplés aux moyens de sortie électriquement conducteurs.

Selon un autre aspect, il est proposé un procédé de fabrication d'un circuit intégré comprenant une réalisation d'au moins une région contenant au moins un matériau thermoélectrique et configurée pour être soumise à au moins un gradient de température résultant d'une circulation d'un courant électrique dans moins une partie du circuit intégré lors de son fonctionnement, et une réalisation de moyens de sortie électriquement conducteurs couplés à ladite ou auxdites régions pour délivrer l'énergie électrique produite par le ou les matériaux thermoélectriques.

Selon un mode de mise en oeuvre dans lequel il est prévu une réalisation d'une partie active du circuit intégré et une réalisation d'un réseau d'interconnexion au dessus de la partie active, la réalisation de ladite ou desdites régions thermoélectriques ainsi que la réalisation des moyens de sortie électriquement conducteurs sont effectuées lors de la réalisation du réseau d'interconnexion.

Selon un mode de mise en oeuvre, la réalisation de ladite ou desdites régions comprend des opérations de gravure entre des lignes d'interconnexion du réseau d'interconnexion situées sur un ou plusieurs niveaux d'interconnexion, de façon à créer des tranchées, et un remplissage de ces tranchées par au moins un matériau thermoélectrique.

Selon un mode de mise en oeuvre, la réalisation d'au moins une région comprend une réalisation d'au moins un via entre des tranchées thermoélectriques situées sur des niveaux d'interconnexion différents, et un remplissage du ou des vias par un matériau thermoélectrique.

Selon un mode de mise en oeuvre, il est également prévu en outre une réalisation de poche d'air au voisinage d'une partie d'au moins une région remplie d'un matériau thermoélectrique.

Selon un mode de mise en oeuvre, il est également prévu en outre une réalisation d'un moyen de stockage d'énergie couplé aux moyens de sortie électriques.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre de façon schématique un exemple de structure d'un circuit intégré ;
- la figure 2 illustre les principales étapes d'un mode de mise en oeuvre d'un procédé selon l'invention ;
- la figure 3 illustre un exemple de réalisation d'un circuit intégré selon l'invention ;
- les figures 4 à 8 illustrent un exemple de réalisation de régions thermoélectriques dans un circuit intégré selon l'invention ;
- la figure 9 illustre schématiquement un autre mode de réalisation d'une partie d'un circuit intégré selon l'invention ;
- la figure 10 illustre encore un autre mode de réalisation d'une partie d'un circuit intégré selon l'invention ; et
- la figure 11 illustre un schéma électrique d'un exemple de moyens de stockage de l'énergie produite par un circuit intégré selon l'invention.

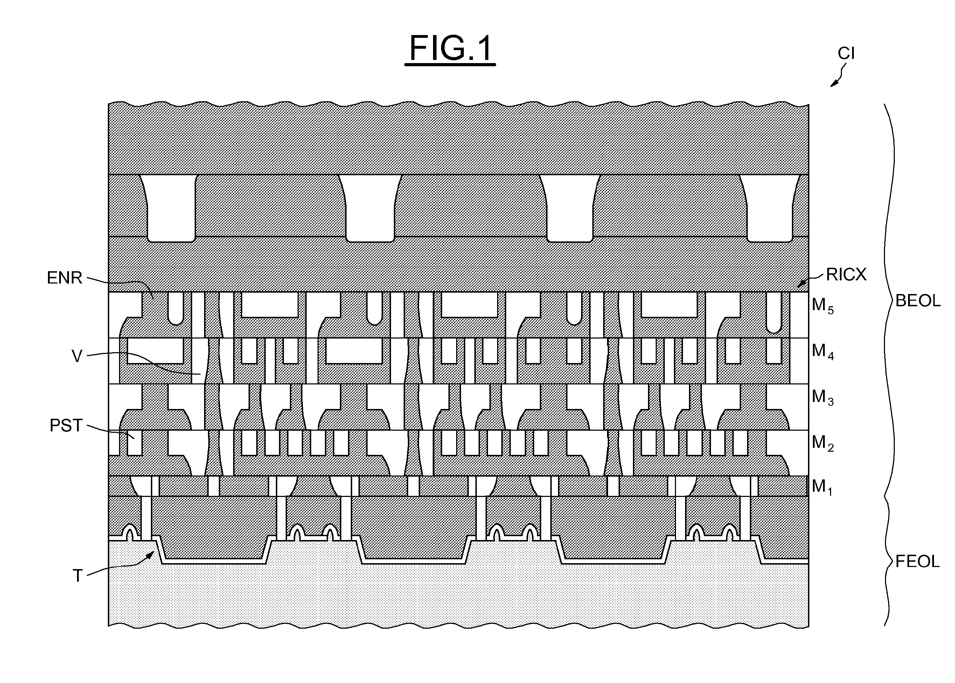

Sur la figure 1, la référence CI désigne un circuit intégré de structure classique comportant une partie active, comportant des composants actifs, par exemple un transistor T. Cette partie active est communément désignée par l'homme du métier sous la dénomination anglosaxonne de « front-end-of-line » (FEOL).

Cette partie active est surmontée par un réseau d'interconnexion RICX destiné à interconnecter les différents composants actifs du circuit intégré entre eux et avec des plots de contact situés sur la partie supérieure du circuit intégré.

Ce réseau d'interconnexion RICX comporte de façon classique un ensemble de pistes électriquement conductrices, par exemple en cuivre ou en aluminium, référencé PST, et se répartissant sur plusieurs niveaux de métallisation Mᵢ, dont cinq sont représentés sur la figure 1.

Le réseau d'interconnexion comporte également des vias V qui sont des orifices électriquement conducteurs reliant certaines des pistes d'un niveau de métallisation à certaines pistes du niveau de métallisation adjacent. Enfin, l'ensemble des pistes et de vias sont mutuellement électriquement isolés par un enrobage isolant ENR ou diélectrique intercouche ILD. Un tel diélectrique peut être par exemple du dioxyde de silicium.

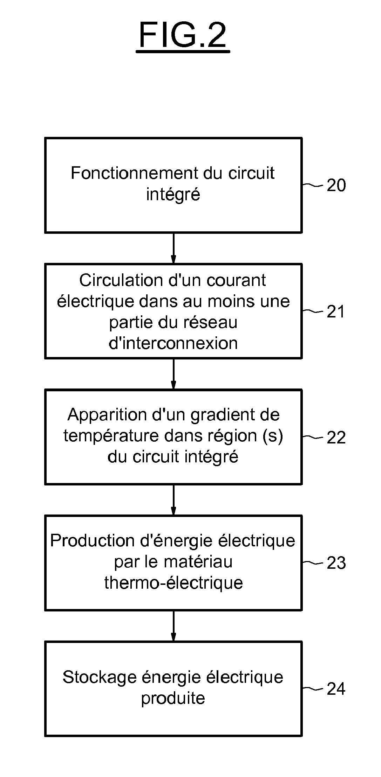

Lors du fonctionnement de ce circuit intégré (étape 20, figure 2), il se produit une circulation d'un courant électrique (étape 21) dans au moins une partie du réseau d'interconnexion RICX.

Cette circulation du courant électrique à un instant donné résulte par exemple du basculement de bascules logiques, de commutation de transistor, .... Ce courant électrique se propage dans une partie du réseau d'interconnexion. A un autre instant, d'autres composants peuvent être sollicités, provoquant également la circulation d'un courant électrique circulant dans une autre partie du réseau d'interconnexion, voire partiellement dans la même partie que précédemment.

La circulation de ces courants provoque (étape 22) l'apparition d'un gradient de température dans au moins une région du circuit intégré, par exemple entre les différents niveaux d'interconnexion électrique M1-M5.

Aussi, est-il prévu de disposer au moins un matériau thermoélectrique, et en pratique un même matériau thermoélectrique, dans une voire plusieurs de ces régions qui sont soumises à un tel gradient de température.

Le matériau thermoélectrique, soumis à un gradient de température, produit alors (étape 23) une énergie électrique (un courant électrique) qui va pouvoir être, comme on le verra plus en détail ci-après, évacuée vers par exemple un moyen de stockage pour stocker l'énergie électrique produite (étape 24).

Il convient d'ores et déjà de noter que ce ou ces gradients de température qui se produisent dans certaines parties du réseau d'interconnexion, résultent du seul fait du fonctionnement propre du circuit intégré. Il n'est pas prévu ici d'insérer dans le circuit intégré un élément spécifique permettant de créer un gradient de température, par exemple un élément capable de refroidir une partie du circuit intégré ou un élément capable de chauffer par lui-même une partie du circuit intégré.

De même, le matériau thermoélectrique ne participe pas au fonctionnement du circuit intégré. Il ne sert ici qu'à exploiter le gradient de température provoqué par le fonctionnement du circuit intégré pour produire de l'énergie électrique autre que celle fournie par le moyen d'alimentation propre du circuit intégré.

En pratique, selon un mode de réalisation, les régions dans lesquelles sera déposé le matériau thermoélectrique avoisinent les lignes d'interconnexion PST qui sont des sources de chaleur.

Tout matériau thermoélectrique convient pour produire l'énergie résultant du gradient de température auquel est soumis le matériau. On peut citer notamment le tellurure de bismuth (Bi₂Te₃) ou bien des alliages de silicium germanium ou encore un matériau de la famille des skutterudites. Ces derniers composés ont une structure cubique formée d'un réseau de type MX3 (avec M désignant un métal de transition et X pouvant être de l'arsenic, du phosphore ou de l'antimoine) avec au centre de ce réseau une grande cage dans laquelle peuvent être insérés des atomes lourds, notamment des terres rares.

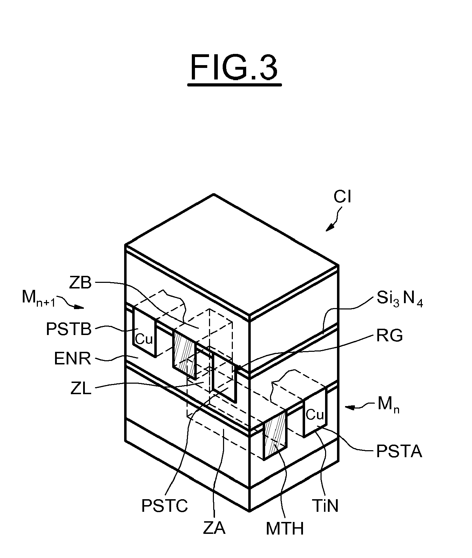

Sur la figure 3, on a représenté une portion du réseau d'interconnexion du circuit intégré CI comportant trois pistes ou lignes d'interconnexion PSTA, PSTB et PSTC. La piste PSTA est située au niveau de métallisation n, tandis que les pistes PSTB et PSTC sont situées au niveau de métallisation n+1.

Il convient de noter ici que la piste PSTA et la piste PSTB peuvent être soit deux lignes d'interconnexion totalement indépendantes, soit reliées ensemble à un autre endroit du circuit intégré par un via.

On suppose que lorsque le circuit intégré fonctionne, la ligne PSTA forme une première source de chaleur tandis que la ligne PSTB forme une deuxième source de chaleur et qu'il existe un gradient de température entre ces deux lignes, par exemple de l'ordre d'une dizaine de degrés C°.

On place donc au voisinage de cette portion du réseau d'interconnexion formée des deux lignes PSTA et PSTB, un matériau thermoélectrique MTH s'étendant dans une région RG possédant deux zones ZA et ZB reliées par une partie de liaison ou via ZL. La zone ZA est située au voisinage de la piste PSTA tandis que la zone ZB est située au voisinage de la piste PSTB. Le matériau thermoélectrique MTH disposé dans cette région est par conséquent soumis au gradient de température ΔT qui apparaît au niveau des lignes d'interconnexion PSTA et PSTB.

Par la présence de ce gradient de température, le matériau thermoélectrique MTH va donc produire de l'énergie électrique.

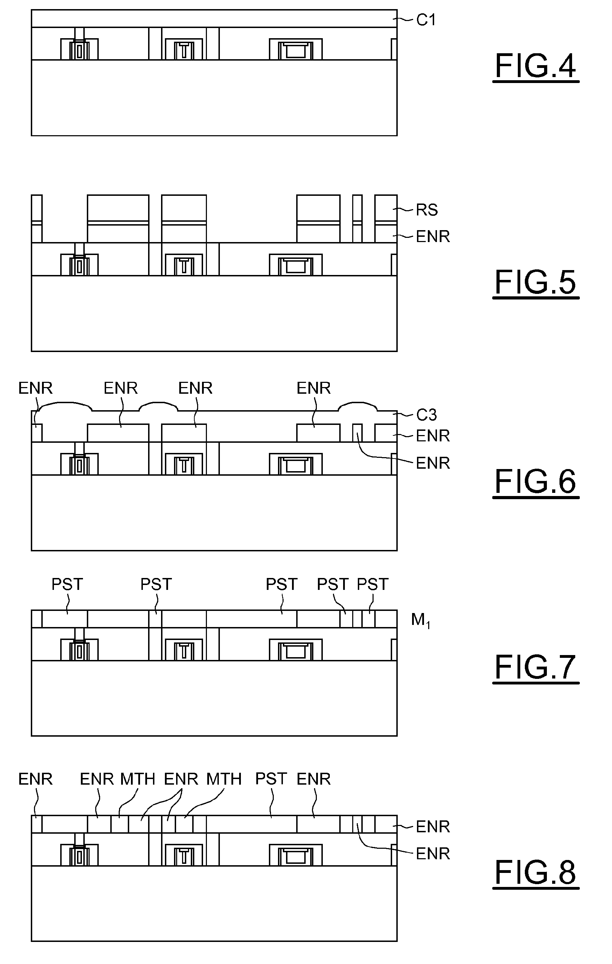

On se réfère maintenant plus particulièrement aux figures 4 à 8 pour décrire en particulier un exemple de réalisation de région contenant un matériau thermoélectrique MTH.

Sur la figure 4, on a illustré à titre d'exemple trois transistors T réalisés dans la partie FEOL du circuit intégré. La réalisation du niveau de métal M1 est alors effectuée de façon classique.

Plus précisément, comme illustré sur la figure 4, on dépose une couche isolante C1, par exemple du dioxyde de silicium, qui sera destinée à former l'enrobage ENR entre les futures pistes et vias.

Puis, après avoir déposé une couche de résine RS et effectué une délimitation par photolithographie et insolation de la résine, des emplacements des futures pistes métalliques PST, on procède à une gravure classique et connue en soi de la couche C1 à travers le masque de résine RS de façon à former des cavités CV.

Puis, on dépose une couche de métal C3, par exemple du cuivre, de façon à remplir les cavités CV (figure 6).

Puis, après polissage mécanochimique, on obtient la configuration illustrée sur la figure 7 avec la réalisation du niveau de métal M1 comportant les pistes métalliques PST enrobées par l'enrobage isolant ENR.

La réalisation des régions RG ou tranchées contenant le matériau métallique MTH au niveau de métallisation M1 peut s'effectuer par des étapes analogues à celles qui viennent d'être décrites. Plus précisément dans une telle éventualité, pour définir les emplacements des différentes tranchées, on procède également à une nouvelle étape de photolithographie et gravure du matériau de la couche C1 disposée entre les listes PST de façon à former des cavités destinées à recevoir le matériau thermoélectrique MTH.

Puis, on procède au dépôt d'une couche de ce matériau thermoélectrique de façon à remplir les cavités et à un polissage mécanochimique de façon à obtenir les cavités remplies avec le matériau MTH.

Dans l'exemple qui vient d'être décrit, les pistes métalliques ont été formées par gravure du matériau diélectrique et remplissage par du métal. En variante, ces pistes pourraient être formées par dépôt d'un métal puis gravure du métal, en particulier lorsqu'on utilise de l'aluminium. Il pourrait en être de même pour la réalisation des régions de matériau thermoélectrique, à savoir formation d'une couche du matériau thermoélectrique puis gravure de ce matériau.

Une telle solution peut être envisagée par exemple lorsqu'on utilise du tellurure de bismuth. Plus précisément, la formation d'une couche de tellurure de bismuth peut s'effectuer par un dépôt chimique en phase vapeur classique ou bien par une technique connue d'épitaxie moléculaire habituellement connue de l'homme du métier sous la dénomination anglosaxonne MBE (Molecular Beam Epitaxy). Les motifs de matériau thermoélectrique peuvent alors être définis de façon classique par photolithographie puis gravure plasma.

Les pistes métalliques et les motifs de matériau thermoélectriques sont ensuite recouverts d'un enrobage isolant tel qu'un matériau diélectrique.

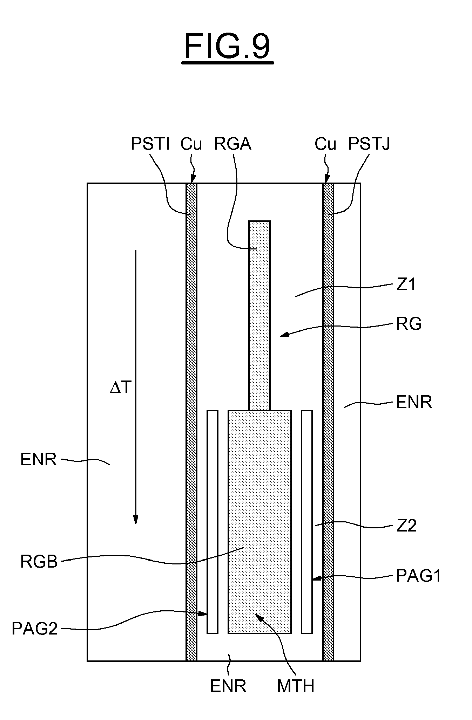

Alors que sur la figure 3 on a illustré un exemple de réalisation d'une région thermoélectrique s'étendant sur plusieurs niveaux de métallisation, il est également possible de réaliser ces régions sur un même niveau de métallisation comme illustré sur la figure 9.

Plus précisément, sur cette figure, les références PSTI et PSTJ désignent deux pistes métalliques, par exemple en cuivre, s'étendant sur un même niveau de métallisation et enrobées d'un enrobage isolant, tel qu'un matériau diélectrique.

On réalise alors dans cet enrobage, par exemple entre les deux pistes PSTI et PSTJ, deux zones Z1 et Z2 présentant des diffusivités thermiques différentes.

A cet égard, on peut réaliser les poches d'air PAG1, PAG2, au voisinage des pistes métalliques PSTI et PSTJ.

Une telle poche d'air ainsi que sa réalisation sont classiques et bien connues de l'homme du métier. Une telle poche d'air est également connue sous la dénomination anglosaxonne de « air gap ».

Entre les deux pistes PSTI et PSTJ, on réalise une cavité ou tranchée que l'on vient remplir de matériau thermoélectrique MTH. La région thermoélectrique RG comporte alors une zone Z2 s'étendant entre les poches d'air PAG1 et PAG2, prolongée par une zone Z1 disposée entre les pistes PSTI et PSTJ mais pas entre les poches d'air.

Ainsi, en raison de la basse diffusivité thermique de l'enrobage ENR dans la zone Z2, provoquée par la présence des poches d'air, il se crée, lors de la circulation d'un courant électrique dans les pistes PSTI et PSTJ, un gradient de température ΔT entre la zone Z1 et la zone Z2, ce qui permet au matériau thermoélectrique MTH de produire de l'énergie électrique.

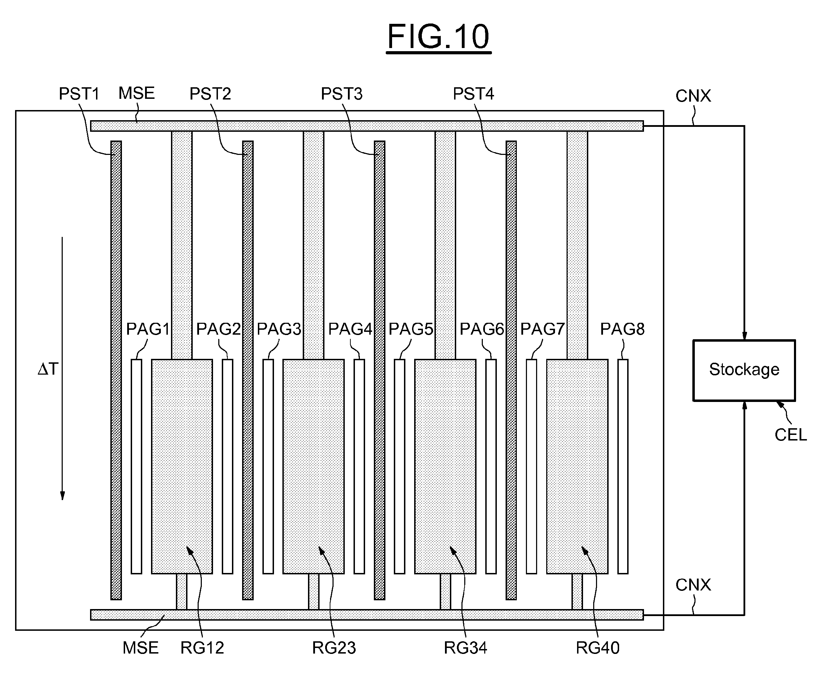

Il est également possible, comme illustré sur la figure 10, de réaliser dans le circuit intégré un niveau spécifique dans le réseau d'interconnexion, par exemple au dessus du dernier niveau de métallisation, de façon à réaliser un nombre important de régions thermoélectriques, ou si les niveaux de métallisation sont trop denses pour permettre l'insertion de tranchées thermoélectriques.

Plus précisément, dans l'exemple illustré sur la figure 10, on réalise sur ce niveau spécifiques des pistes métalliques PST1, PST2, PST3, PST4 reliées bien entendu à des pistes métalliques de niveau inférieur par des vias.

Puis, entre ces pistes métalliques, on réalise des régions thermoélectriques RG12, RG23, RG34 et RGB40, analogues par exemple à celles qui ont été décrites en référence à la figure 9.

Chacune de ces régions avoisine partiellement des poches d'air PAG1, PAG2, PAG3, PAG4, PAG5, PAG6, PAG7, PAG8.

Toutes ces régions sont par conséquent soumises au gradient de température ΔT lors de la circulation de courant électrique dans les pistes PST1, PST2, PST3 et PST4.

Par ailleurs, il est prévu dans cet exemple, des moyens de sortie électriques MSE formés de deux bandes de matériau thermoélectrique respectivement reliées aux deux extrémités de chacune des régions thermoélectriques RG12, RG23, RG34 et RG40.

Ces moyens de sortie électriques MSE sont reliés par une connexion électriquement conductrice CNX, par exemple un réseau de lignes d'interconnexion et de vias, à un circuit spécifique de stockage CEL réalisé par exemple dans la partie FEOL du circuit intégré.

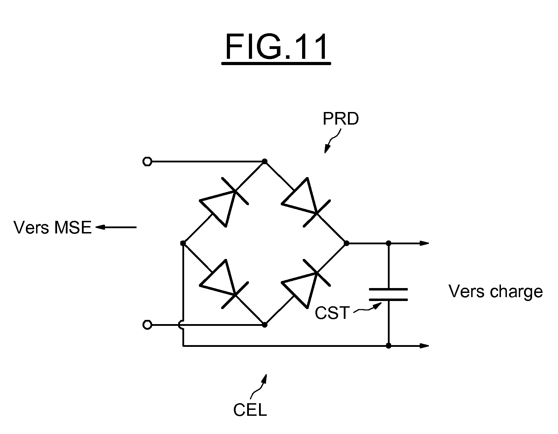

La figure 11 illustre de façon schématique un schéma électrique d'un tel circuit CEL permettant de stocker l'énergie produite par les régions thermoélectriques au cours du fonctionnement du circuit intégré.

Plus précisément, dans l'exemple décrit ici, qui n'est nullement limitatif, le circuit CEL comporte un pont redresseur PRD à diodes dont les zones d'entrée sont couplées aux moyens de sortie MSE par l'intermédiaire de la connexion CNX.

La sortie du pont redresseur est connectée aux deux bornes d'un condensateur de stockage CST qui va pouvoir éventuellement restituer l'énergie stockée vers une charge du circuit intégré.

L'invention n'est pas limitée aux modes de mise en oeuvre et de réalisation qui viennent d'être décrits mais en embrasse toutes les variantes.

Ainsi un circuit intégré peut incorporer dans sa partie supérieure (BEOL) contenant le réseau d'interconnexion, des lignes métalliques fictives (« dummy lines » ou « dummies » selon des dénominations anglosaxonnes bien connues de l'homme du métier). Ces lignes fictives servent à densifier la partie supérieure du circuit intégré lorsque le réseau d'interconnexion n'est pas assez dense, afin de faciliter le procédé de fabrication et en particulier les étapes de polissage mécano-chimique. Dans un tel cas il est possible de remplacer certaines lignes fictives ou portions de lignes fictives disposées au voisinage de lignes d'interconnexion, par des régions de matériau thermoélectrique. L'une des régions thermoélectriques MTH illustrées sur la figure 8 peut par exemple avoir été réalisée à un emplacement initialement prévu pour une ligne d'interconnexion fictive. Un tel mode de réalisation est encore plus aisément compatible avec un process de réalisation classique de circuit intégré.

## Revendications

1. Procédé de génération d'énergie dans un circuit intégré, comprenant une production (22) d'au moins un gradient de température dans au moins une région du circuit intégré résultant d'une circulation d'un courant électrique dans au moins une partie du circuit intégré lors de son fonctionnement, et une production (23) d'énergie électrique à partir d'au moins un matériau thermoélectrique contenu dans ladite ou lesdites régions soumise audit ou auxdits gradients de température.

2. Procédé selon la revendication 1, dans lequel le circuit intégré comprenant des composants actifs (T) et un réseau d'interconnexion électriquement conducteur (RICX) configuré pour interconnecter les composants actifs, ladite production d'au moins un gradient de température résulte d'une circulation d'un courant électrique dans au moins une partie du réseau d'interconnexion (PSTA, PSTB) lors du fonctionnement d'au moins une partie du circuit intégré, et on loge le ou les matériaux thermoélectriques (MTH) dans une ou plusieurs régions réalisées au voisinage d'une ou de plusieurs portions du réseau d'interconnexion.

3. Procédé selon la revendication 2, dans lequel le réseau d'interconnexion comprend plusieurs niveaux d'interconnexion, et on réalise l'une au moins desdites régions sur et entre des niveaux d'interconnexion différents (Mₙ, Mₙ₊₁).

4. Procédé selon la revendication 2 ou 3, dans lequel le réseau d'interconnexion comprend plusieurs niveaux d'interconnexion, et on réalise l'une au moins desdites régions (RG) sur un même niveau d'interconnexion.

5. Procédé selon l'une des revendications 2 à 4, dans lequel on réalise l'une au moins desdites régions de façon à ce qu'elle avoisine au moins deux zones de diffusivités thermiques différentes (PAG1, PAG2) d'un enrobage électriquement isolant (ENR) d'une portion du réseau d'interconnexion.

6. Procédé selon l'une des revendications 2 à 5, dans lequel la partie du circuit intégré comprenant le réseau d'interconnexion comporte des emplacements pour des lignes d'interconnexion fictives, et on réalise l'une au moins desdites régions thermoélectriques à au moins un des emplacements prévus pour lesdites lignes d'interconnexion fictives.

7. Procédé selon l'une des revendications précédentes, dans lequel on stocke l'énergie produite dans un moyen de stockage (CEL) ménagé dans le circuit intégré.

8. Circuit intégré, comprenant au moins une région (RG) contenant au moins un matériau thermoélectrique (MTH) et configurée pour être soumise à au moins un gradient de température résultant d'une circulation d'un courant électrique dans moins une partie du circuit intégré (PSTA, PSTB) lors de son fonctionnement, et des moyens de sortie électriquement conducteurs couplés à ladite ou auxdites régions pour délivrer l'énergie électrique produite par le ou les matériaux thermoélectriques.

9. Circuit intégré selon la revendication 8, comprenant des composants actifs et un réseau d'interconnexion électriquement conducteur configuré pour interconnecter les composants actifs, et dans lequel ladite ou lesdites régions (RG) contenant au moins un matériau thermoélectrique (MTH) et configurée pour être soumise à au moins un gradient de température sont situées au voisinage d'une ou de plusieurs portions du réseau d'interconnexion.

10. Circuit intégré selon la revendication 9, dans lequel le réseau d'interconnexion comprend plusieurs niveaux d'interconnexion, et l'une au moins desdites régions s'étend sur et entre des niveaux d'interconnexion différents (Mₙ, Mₙ₊₁).

11. Circuit intégré selon la revendication 9 ou 10, dans lequel le réseau d'interconnexion comprend plusieurs niveaux d'interconnexion, et l'une au moins desdites régions (RG) s'étend sur un même niveau d'interconnexion.

12. Circuit intégré selon l'une des revendications 9 à 11, dans lequel l'une au moins desdites régions (RG) avoisine au moins deux zones de diffusivités thermiques différentes (PAG1, PAG2) d'un enrobage électriquement isolant d'une portion du réseau d'interconnexion.

13. Circuit intégré selon la revendication 12, dans lequel l'une des deux zones (Z2) comporte une poche d'air.

14. Circuit intégré selon l'une des revendications 8 à 13, dans lequel l'une au moins desdites régions (RG) s'étend entre au moins des parties de lignes d'interconnexion.

15. Circuit intégré selon l'une des revendications 8 à 14, comprenant en outre des moyens de stockage d'énergie électrique (CEL), électriquement couplés auxdits moyens de sortie électriquement conducteurs (MSE).

16. Procédé de fabrication d'un circuit intégré, **caractérisé en ce qu'**il comprend une réalisation d'au moins une région (RG) contenant au moins un matériau thermoélectrique et configurée pour être soumise à au moins un gradient de température résultant d'une circulation d'un courant électrique dans moins une partie du circuit intégré lors de son fonctionnement, et une réalisation de moyens de sortie électriquement conducteurs (MSE) couplés à ladite ou auxdites régions pour délivrer l'énergie électrique produite par le ou les matériaux thermoélectriques.

17. Procédé selon la revendication 16, comprenant une réalisation d'une partie active du circuit intégré et une réalisation d'une partie d'interconnexion au dessus de la partie active, et dans lequel la réalisation de ladite ou desdites régions (RG) ainsi que la réalisation des moyens de sortie électriquement conducteurs (MSE) sont effectuées lors de la réalisation de ladite partie d'interconnexion.

18. Procédé selon la revendication 16 ou 17, dans lequel la réalisation de ladite ou desdites régions comprend des opérations de gravure entre des lignes d'interconnexion du réseau d'interconnexion situées sur un ou plusieurs niveaux d'interconnexion, de façon à créer des tranchées, et un remplissage de ces tranchées par au moins un matériau thermoélectrique (MTH), ou bien des opérations de gravure d'une couche de matériau thermoélectrique préalablement formée.

19. Procédé selon la revendication 18, dans lequel la réalisation d'au moins une région comprend une réalisation d'au moins un via (ZL) entre des tranchées thermoélectriques situées sur des niveaux d'interconnexion différents, et un remplissage du ou des vias par un matériau thermoélectrique.

20. Procédé selon l'une des revendications 16 à 19, comprenant en outre une réalisation de poches d'air (PAG1, PAG2) au voisinage d'une partie d'au moins une région remplie d'un matériau thermoélectrique.

21. Procédé selon l'une des revendications 16 à 20, dans lequel on réalise au moins une région thermoélectrique à un emplacement initialement prévu pour au moins une partie d'au moins une ligne d'interconnexion fictive du circuit intégré.

22. Procédé selon l'une des revendications 16 à 21, comprenant en outre une réalisation d'un moyen de stockage d'énergie (CEL) couplé aux moyens de sortie électriques (MSE).
